# EUROPEAN PATENT APPLICATION

(11) **EP 4 528 832 A1**
(43) Date of publication of application: **26.03.2025**
(21) Application number: 24152800.9
(22) Date of filing: 19.01.2024
(51) Int. Cl.: H01L 33/48, H01L 33/56, H01L 33/62

(54) **FULLY LUMINOUS LIGHT EMITTING DIODE LIGHT SOURCE**

(30) Priority: 21.09.2023 CN 202322566969 U; 14.11.2023 US 202318509003
(71) Applicant: Guangxi Xinyi Phoyoelectric Technology Co.,Ltd, Wuzhou Guangxi (CN)
(72) Inventor: WU, Xianquan, Wuzhou,Guangxi (CN)
(74) Representative: Ipey

(57) **Abstract**

The present disclosure provides a fully luminous LED light source including: a lead frame body (1), a positive electrode terminal (2), a negative electrode terminal (3), an LED chip (4), and a packaging colloid (6). The lead frame body is made of a light-transmissive material. The LED chip is electrically connected to the electrode terminals. The packaging colloid is disposed at a top end of the lead frame body, and the LED chip is packaged and fixed inside said packaging colloid. According to the fully luminous LED light source provided by the present disclosure, through the lead frame body made of the light-transmissive material and the LED chip packaged on a surface of said body, LED light can be transmitted through the surrounding and top end of the packaging colloid, and through the back of the lead frame body, thereby improving light-emitting dead angle, achieving full illumination, reducing production costs, and improving practicality of the device.

## Description

### TECHNICAL FIELD

The present disclosure relates to the technical field of light emitting diode (LED) light sources, and in particular, to a fully luminous LED light source.

### BACKGROUND

In LED lighting, a semiconductor solid light-emitting device is used. The device takes a solid semiconductor chip as the luminescent material, excess energy is released through the recombination of carriers in a semiconductor to cause photon emission, and red light, yellow light, blue light, and green light are directly emitted. On this basis, light of any color can be emitted by adding phosphor by means of the principle of three primary colors. The semiconductor chip is a P-N junction, which can directly convert electricity into light. The semiconductor chip is an LED chip including a semiconductor. One end of the LED chip is attached to a lead frame (substrate) as a negative electrode, and the other end is connected to the positive electrode of a power supply. Then the entire LED chip is encapsulated with epoxy resin to form an LED packaging structure.

The front and back sides of the lead frame of the existing LED packaging structure are opaque. The LED chip (semiconductor chip) packaged on one side of the lead frame can only emit light on this side of the lead frame. Light cannot be transmitted from the other side of the lead frame due to the obstruction of the lead frame. The existing solution is to encapsulate LED chips on both sides of the lead frame to achieve full illumination. However, this solution requires twice the number of LED chips to be packaged, which increases the cost.

### SUMMARY

The present disclosure provides a fully luminous LED light source, and aims to solve the problem that the existing LED fully luminous solution requires twice the number of LED chips to be packaged, which increases the device cost.

The present disclosure provides a fully luminous LED light source, which includes a lead frame body, a positive electrode terminal, a negative electrode terminal, an LED chip, and a packaging colloid, where the lead frame body is made of a light-transmissive material; the positive electrode terminal and the negative electrode terminal exist in pairs, and are not in contact; the LED chip is electrically connected to the positive electrode terminal and the negative electrode terminal; and the packaging colloid is disposed at a top end of the lead frame body, and the LED chip is packaged and fixed inside the packaging colloid.

Preferably, the lead frame body is in the shape of a flat plate, and is capable of being made of glass or fiberglass cloth or a resin adhesive or a polycarbonate (PC) material; the positive electrode terminal and the negative electrode terminal are respectively disposed on two sides of the top end of the lead frame body; two leads are respectively connected to two ends of the LED chip, and the two leads are respectively bonded to the positive electrode terminal and the negative electrode terminal; and the leads are packaged and fixed inside the packaging colloid.

Preferably, a positive electrode pad and a negative electrode pad are provided at a bottom end of the lead frame body, the positive electrode pad is arranged opposite to the positive electrode terminal, the positive electrode pad is electrically conducted with the positive electrode terminal, the negative electrode pad is arranged opposite to the negative electrode terminal, and the negative electrode pad is electrically conducted with the negative electrode terminal.

Preferably, outer sides of the positive electrode terminal and the negative electrode terminal are each provided with an arc-shaped notch, copper is provided on a side wall of the arc-shaped notch, the positive electrode terminal is electrically conducted with the positive electrode pad through the copper, and the negative electrode terminal is electrically conducted with the negative electrode pad through the copper.

Preferably, a positive electrode conductive connection region and a negative electrode conductive connection region are provided at the top end of the lead frame body, and an interval is provided between the negative electrode conductive connection region and the positive electrode conductive connection region.

Preferably, the LED chip is disposed in the negative electrode conductive connection region, the LED chip and the positive electrode conductive connection region are bonded through the lead, and the LED chip is packaged and fixed with the positive electrode conductive connection region and the negative electrode conductive connection region through the packaging colloid.

Compared with the prior art, the embodiments of the present disclosure mainly have the following beneficial effects:

Through the lead frame body made of the light-transmissive material and the LED chip packaged on a surface of the lead frame body, light from the LED chip can be transmitted through the surrounding and top end of the packaging colloid, and through the back of the lead frame body, thereby improving the light-emitting dead angle, achieving full illumination, reducing production costs, and improving the practicality of the device.

### BRIEF DESCRIPTION OF THE DRAWINGS

FIG. 1 is a front schematic structural diagram according to the present disclosure;
FIG. 2 is a top schematic structural diagram according to the present disclosure; and
FIG. 3 is a bottom schematic structural diagram according to the present disclosure.

Reference Numerals: 1. Lead frame body; 2. Positive electrode terminal; 21. Positive electrode pad; 22. Positive electrode conductive connection region; 3. Negative electrode terminal; 31. Negative electrode pad; 32. Negative electrode conductive connection region; 4. LED chip; 5. Lead; 6. Packaging colloid; and 7. Arc-shaped notch.

### DETAILED DESCRIPTION OF THE EMBODIMENTS

Unless otherwise defined, all technical and scientific terms used in the present application have the same meanings as commonly understood by those skilled in the technical field of the present application. The terms used in the specification of the present application are merely intended to describe the specific embodiments, rather than limit the present application. The terms "includes" and "has" in the specification, claims, and accompanying drawings of the present application and any variations thereof are intended to encompass without excluding other content. The terms "first", "second", and the like in the specification and claims or the accompanying drawings of the present application are intended to distinguish different objects, rather than describe a specific order or a primary/secondary relationship.

The term "embodiment" mentioned herein means that a specific feature, structure, or characteristic described in combination with the embodiment may be included in at least one embodiment of the present application. The phrase appearing in different parts of the specification does not necessarily refer to the same embodiment or an independent or alternative embodiment exclusive of other embodiments. It may be explicitly or implicitly appreciated by those skilled in the art that the embodiments described herein may be combined with another embodiment.

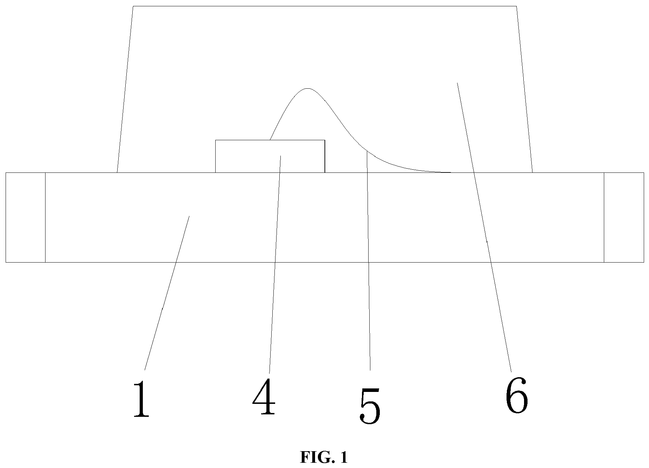

An embodiment of the present disclosure provides a fully luminous LED light source, as shown in FIG. 1 to FIG. 3, including a lead frame body 1, a positive electrode terminal 2, a negative electrode terminal 3, an LED chip 4, and a packaging colloid 6, where the lead frame body 1 is made of a light-transmissive material; the positive electrode terminal 2 and the negative electrode terminal 3 exist in pairs, and are not in contact; the LED chip 4 is electrically connected to the positive electrode terminal 2 and the negative electrode terminal 3; and the packaging colloid 6 is disposed at a top end of the lead frame body 1, and the LED chip 4 is packaged and fixed inside the packaging colloid 6.

It should be noted that the front and back sides of the lead frame of the existing LED packaging structure are opaque. The LED chip (semiconductor chip) packaged on one side of the lead frame can only emit light on this side of the lead frame. As for the other side of the lead frame, light cannot be transmitted from this side due to the obstruction of the lead frame. Therefore, the existing solution is to encapsulate LED chips on both sides of the lead frame to achieve full illumination. However, this solution requires twice the number of LED chips to be packaged. To reduce the device cost, this solution employs the lead frame body 1 and the packaging colloid 6 to make four side walls and the top and bottom surfaces of the LED chip 4 transparent, such that the light can be transmitted without obstruction and the transmission surface is wide.

Specifically, in this embodiment, this solution mainly includes a lead frame body 1, a positive electrode terminal 2, a negative electrode terminal 3, an LED chip 4, and a packaging colloid 6. The positive electrode terminal 2 and the negative electrode terminal 3 provide electrical connections for the LED chip 4. The lead frame body 1 and the packaging colloid 6 are employed to fix the relative position of the LED chip 4. The lead frame body 1 made of the light-transmissive material and the packaging colloid 6 ensure that the light can be transmitted without obstruction.

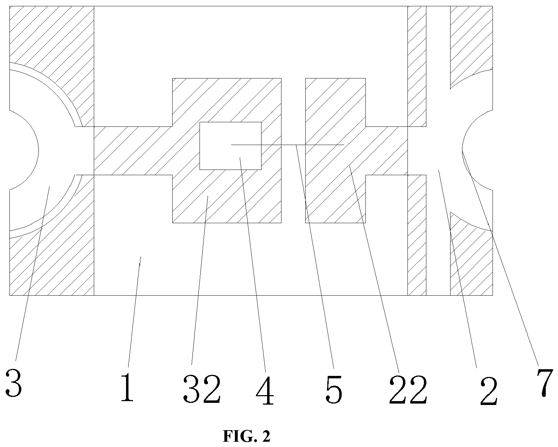

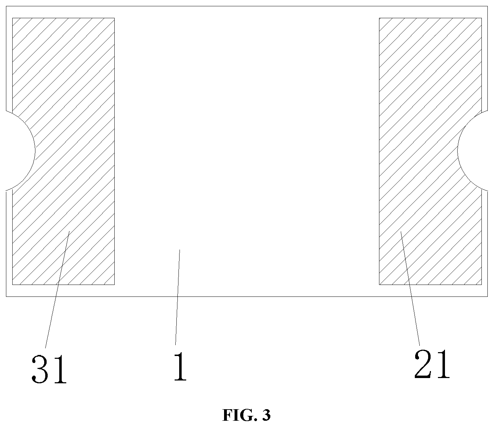

In a further preferred embodiment of the present disclosure, as shown in FIG. 2 and FIG. 3, the lead frame body 1 is in the shape of a flat plate, and is capable of being made of glass or fiberglass cloth or a resin adhesive or a PC material; the positive electrode terminal 2 and the negative electrode terminal 3 are respectively disposed on two sides of the top end of the lead frame body 1; two leads 5 are respectively connected to two ends of the LED chip 4, and the two leads 5 are respectively bonded to the positive electrode terminal 2 and the negative electrode terminal 3; and the leads 5 are packaged and fixed inside the packaging colloid 6.

In this embodiment, the lead frame body 1 made of glass or fiberglass cloth or a resin adhesive or a PC material ensures that the light can be transmitted without obstruction. The positive electrode terminal 2 and the negative electrode terminal 3 are separately arranged to avoid short circuit in direct connection of lines. By arranging the leads 5, a power line of the LED chip 4 is connected to ensure that the LED chip 4 can emit light normally.

In a further preferred embodiment of the present disclosure, a positive electrode pad 21 and a negative electrode pad 31 are provided at a bottom end of the lead frame body 1, the positive electrode pad 21 is arranged opposite to the positive electrode terminal 2, the positive electrode pad 21 is electrically conducted with the positive electrode terminal 2, the negative electrode pad 31 is arranged opposite to the negative electrode terminal 3, and the negative electrode pad 31 is electrically conducted with the negative electrode terminal 3.

In this embodiment, by arranging the positive electrode pad 21 and the negative electrode pad 31, the device is conveniently welded to a circuit board of a lamp panel, and when the lamp panel is broken down in the later period, each LED packaging light source can be disassembled, checked and rewelded, without destroying the LED packaging structure.

In a further preferred embodiment of the present disclosure, outer sides of the positive electrode terminal 2 and the negative electrode terminal 3 are each provided with an arc-shaped notch 7, copper is provided on a side wall of the arc-shaped notch 7, the positive electrode terminal 2 is electrically conducted with the positive electrode pad 21 through the copper, and the negative electrode terminal 3 is electrically conducted with the negative electrode pad 31 through the copper.

In this embodiment, by arranging the semicircular arc-shaped notch 7, the lead frame body 1 is united with the adjacent lead frame body 1 unit to form a circular through hole, such that during manufacturing, it is convenient to coat the hole wall with the copper by the copper sinking process in the PCB manufacturing process, thereby facilitating the device production.

In a further preferred embodiment of the present disclosure, a positive electrode conductive connection region 22 and a negative electrode conductive connection region 32 are provided at the top end of the lead frame body 1, an interval is provided between the negative electrode conductive connection region 32 and the positive electrode conductive connection region 22, and the negative electrode conductive connection region 32 and the positive electrode conductive connection region 22 can be filled with a copper or aluminum conductive material.

In this embodiment, the negative electrode conductive connection region 32 and the positive electrode conductive connection region 22 are arranged at intervals to avoid short circuit caused by direct connection of the two and ensure normal light-emitting operation of the LED chip 4, and the circuit passing area is increased by employing the two to improve the heat dissipation efficiency.

In a further preferred embodiment of the present disclosure, the LED chip 4 is disposed in the negative electrode conductive connection region 32, the LED chip 4 and the positive electrode conductive connection region 22 are bonded through the lead 5, and the LED chip 4 is packaged and fixed with the positive electrode conductive connection region 22 and the negative electrode conductive connection region 32 through the packaging colloid 6.

In this embodiment, by arranging the leads 5, the power line is connected, and a power element is packaged by the packaging colloid 6 to solve the hidden trouble of electric leakage.

It should be noted that, for the sake of simplicity, the foregoing examples of the method are described as a series of action combinations, but those skilled in the art will recognize that the present disclosure is not limited by the sequence of actions described, certain steps may be carried out in another order or at the same time according to the present disclosure. Secondly, it should be understood by those skilled in the art that the examples described in the specification are preferred examples and the involved actions and modules are not necessarily necessary for the present disclosure.

In several examples provided herein, it should be understood that the disclosed apparatus may be implemented in other manners. For example, the described apparatus embodiments are merely examples. For example, division into the units is merely logical function division and may be other division in actual implementation. For example, a plurality of units or components may be combined or integrated into another system, or some features may be ignored or not performed. In other respects, the intercoupling or direct coupling or communication connection shown or discussed may be indirect coupling or communication connection through some interfaces, apparatuses, or units, or may be implemented in an electrical or other forms.

The units described as separate parts may be or may not be physically separate, and parts displayed as units may be or may not be physical units, may be located in one position, or may be distributed on a plurality of network units. Some or all of the units may be selected according to actual needs to achieve the objectives of the solutions of embodiments.

The above examples are only used for describing the technical solutions of the present disclosure, and are not intended to limit the present disclosure. Apparently, the described examples are some rather than all of the examples of the present disclosure. All other examples obtained by a person of ordinary skill in the art based on the examples of the present disclosure without creative efforts shall fall within the protection scope of the present disclosure. Although the present application is described in detail with reference to the above embodiments, a person of ordinary skill in the art should understand that they can still modify the technical solutions described in the above embodiments or make equivalent substitutions for some technical features therein, and these modifications or substitutions do not make the essence of corresponding technical solutions depart from the scope of the technical solutions of the embodiments of the present application.

## Claims

1. A fully luminous light emitting diode (LED) light source, comprising a lead frame body (1), a positive electrode terminal (2), a negative electrode terminal (3), an LED chip (4), and a packaging colloid (6), wherein
the lead frame body (1) is made of a light-transmissive material;
the positive electrode terminal (2) and the negative electrode terminal (3) exist in pairs, and are not in contact;
the LED chip (4) is electrically connected to the positive electrode terminal (2) and the negative electrode terminal (3); and
the packaging colloid (6) is disposed at a top end of the lead frame body (1), and the LED chip (4) is packaged and fixed inside the packaging colloid (6).

2. The fully luminous LED light source according to claim 1, wherein the lead frame body (1) is in the shape of a flat plate, and is made of glass, fiberglass cloth, a resin adhesive, or a polycarbonate (PC) material;
the positive electrode terminal (2) and the negative electrode terminal (3) are respectively disposed on two sides of the top end of the lead frame body (1);
two leads (5) are respectively connected to two ends of the LED chip (4), and the two leads (5) are respectively bonded to the positive electrode terminal (2) and the negative electrode terminal (3); and
the leads (5) are packaged and fixed inside the packaging colloid (6).

3. The fully luminous LED light source according to claim 1, wherein a positive electrode pad (21) and a negative electrode pad (31) are provided at a bottom end of the lead frame body (1), the positive electrode pad (21) is arranged opposite to the positive electrode terminal (2), the positive electrode pad (21) is electrically conducted with the positive electrode terminal (2), the negative electrode pad (31) is arranged opposite to the negative electrode terminal (3), and the negative electrode pad (31) is electrically conducted with the negative electrode terminal (3).

4. The fully luminous LED light source according to claim 3, wherein outer sides of the positive electrode terminal (2) and the negative electrode terminal (3) each are provided with an arc-shaped notch (7), copper is provided on a side wall of the arc-shaped notch (7), the positive electrode terminal (2) is electrically conducted with the positive electrode pad (21) through the copper, and the negative electrode terminal (3) is electrically conducted with the negative electrode pad (31) through the copper.

5. The fully luminous LED light source according to claim 1, wherein a positive electrode conductive connection region (22) and a negative electrode conductive connection region (32) are provided at the top end of the lead frame body (1), and an interval is provided between the negative electrode conductive connection region (32) and the positive electrode conductive connection region (22).

6. The fully luminous LED light source according to claim 5, wherein the LED chip (4) is disposed in the negative electrode conductive connection region (32), the LED chip (4) and the positive electrode conductive connection region (22) are bonded through the lead (5), and the LED chip (4) is packaged and fixed with the positive electrode conductive connection region (22) and the negative electrode conductive connection region (32) through the packaging colloid (6).
